(19) Europäisches Patentamt
European Patent Office
Office européen des brevets

(11) Veröffentlichungsnummer: **0 327 838**
**A2**

(12) **EUROPÄISCHE PATENTANMELDUNG**

(21) Anmeldenummer: 89100699.1

(51) Int. Cl.4: **B32B 31/08**

(22) Anmeldetag: 17.01.89

(30) Priorität: 10.02.88 DE 3803997

(43) Veröffentlichungstag der Anmeldung:
16.08.89 Patentblatt 89/33

(84) Benannte Vertragsstaaten:
FR GB IT SE

(71) Anmelder: Held, Kurt
Alte Strasse 1
D-7218 Trossingen 2(DE)

(72) Erfinder: Held, Kurt
Alte Strasse 1
D-7218 Trossingen 2(DE)

(54) **Vorrichtung zur kontinuierlichen Herstellung von Multilayer-Leiterplatten.**

(57) Die Erfindung betrifft eine Vorrichtung zur kontinuierlichen Herstellung von Multilayer-Leiterplatten mit einer zwei endlose, in einem Pressengestell übereinander angeordnete und über je zwei Umlenktrommeln geführte Preßbänder besitzende Doppelbandpresse zur Verpressung von Multilayer-Innenlagen, an deren Rändern Fixierlöcher eingebracht sind. Vor der Doppelbandpresse sind hintereinanderliegende Abwickeleinheiten für die auf einer Rolle vorliegenden Multilayer-Innenlagenbahnen mit dazwischen liegenden Abwickeleinheiten für die Prepreg-Bahnen oder Auflegeeinrichtungen für die als Platten vorliegenden Multilayer-Innenlagen mit dazwischen liegenden Abwickeleinheiten für die Prepreg-Bahnen angeordnet. Wenigstens ein Preßband der Doppelbandpresse besitzt an mindestens einem Rand in regelmäßigen Abständen auf der Außenseite·des Preßbandes angebrachte Vorsprünge, die zu den Fixierlöchern korrespondierenden, um ein paßgenaues Übereinanderlegen der Multilayer-Innenlagen zu einem die Multilayer-Anordnung darstellenden Schichtgebilde und eine Fixierung der Multilayer-Innenlagen dieses Schichtgebildes während der Verpressung in der Doppelbandpresse zu gestatten.

EP 0 327 838 A2

Fig. 1

## Vorrichtung zur kontinuierlichen Herstellung von Multilayer-Leiterplatten

Die Erfindung betrifft eine Vorrichtung zur kontinuierlichen Herstellung von Multilayer-Leiterplatten gemäß dem Oberbegriff des Patentanspruchs 1.

In der Elektronik- und Elektro-Industrie werden seit langem Leiterplatten für die Montage der Bauelemente und deren elektrischen Verbindung untereinander eingesetzt. Als Ausgangsmaterial für solche Leiterplatten dienen kupferkaschierte Laminate. Diese kupferkaschierten Laminate bestehen aus einem Schichtstoffkern, wobei sich auf mindestens einer Oberfläche dieses Schichtstoffkerns eine elektrolytisch abgeschiedene Kupferfolie von hohem Reinheitsgrad befindet, die mit dieser Oberfläche fest verbunden ist. Der Schichtstoffkern wiederum setzt sich aus einzelnen Lagen von mit vorkondensiertem Harz getränkten Trägermaterialien zusammen, dem sogenannten Prepreg. Dieses Prepreg besteht beispielsweise aus einzelnen Lagen von mit Epoxyharz imprägniertem Glasfasergewebe. Das Prepreg wird unter Einwirkung von Hitze und Druck mit den Kupferfolien zum kupferkaschierten Laminat verpreßt. Bei einem solchen kupferkaschierten Laminat diene der Schichtstoffkern als Träger- und Isolationsmaterial, die Kupferschicht zur Herstellung von Leiterbahnen. Die Herstellung dieser Leiterbahnen auf dem kupferkaschierten Laminat, das heißt die Fertigstellung der Leiterplatte, erfolgt in der Regel durch Ätzen.

Auf Grund der immer größer werdenden Integrationsdichte der elektronischen Bausteine mit einer Vielzahl von Anschlüssen, werden anstelle der einfachen Leiterplatten immer häufiger Multilayer-Leiterplatten verwendet. Diese Multilayer-Leiterplatten bestehen aus einzelnen, das jeweilige Leiterbahnmuster enthaltenden Leiterplatten, die paßgenau übereinander liegen, wobei sich zwischen jeweils zwei einzelnen Leiterplatten eine Lage aus Schichtstoff befindet. Die auf den beiden Oberflächen befindlichen Leiterplatten heißen Multilayer-Außenlagen, während die dazwischen liegenden Leiterplatten Multilayer-Innenlagen genannt werden. Bei diesen Multilayer-Platten erreicht man vorteilhafterweise eine größere Freizügigkeit und Dichte in der Leiterbahnführung, da diese zur kreuzungsfreien Führung auf mehreren Ebenen angeordnet werden können.

Aus der DE-OS 33 07 057 ist ein kontinuierliches Verfahren und eine Vorrichtung zur Herstellung von Multilayer-Leiterplatten bekannt. Bei diesem Verfahren werden an den Rändern einer kupferkaschierten Laminatbahn, die kontinuierlich auf einer Doppelbandpresse hergestellt wird, nach dem Verlassen der Doppelbandpresse Fixierlöcher eingebracht, die einen konstanten Abstand zueinander besitzen. Die Weiterverarbeitung dieser kupferkaschierten Laminatbahnen zu Multilayer-Leiterplatten erfolgt in Referenz zu diesen Fixierlöchern, wobei zwei Vorgehensweisen genannt werden.

Bei der ersten Vorgehensweise wird die kupferkaschierte Laminatbahn anhand der Fixierbohrungen in einzelne Platten zerschnitten, die dann getrennt durch Ätzen, Bohren, und dergleichen mit dem entsprechenden Leiterbahnmuster versehen werden, wobei die Fixierlöcher als Referenz für die Lage des Leiterbahnmusters der jeweiligen Multilayer-Innenlage dienen. Bei der zweiten Vorgehensweise wird jeweils ein Leiterbahnmuster wiederholt in Referenz zu den Fixierlöchern auf der kupferkaschierten Laminatbahn hergestellt, so daß man eine Laminatbahn von regelmäßig hintereinander angeordneten Multilayer-Innenlagen, die Multilayer-Innenlagenbahn, erhält.

Die in der DE-OS 33 07 057 gezeigte Vorrichtung zur kontinuierlichen Herstellung von Multilayer-Leiterplatten besteht aus einer Doppelbandpresse mit zwei endlosen, über Kettenrädern synchron umlaufenden Stiftketten, die jeweils an einem Rand der Preßzone der Doppelbandpresse durch diese hindurchgeführt werden. Vor der Doppelbandpresse sind Abwickeleinheiten für Prepreg-Bahnen angeordnet. Die gemäß der ersten Verfahrensweise hergestellten Multilayer-Innenlagen werden entsprechend dem gewünschten Aufbau der Multilayer-Leiterplatte mittels der Fixierlöcher auf die Stiftkette aufgelegt, wobei zwischen jeweils zwei Multilayer-Innenlagen eine Prepreg-Bahn, die von Abwickeleinheiten abgewickelt wird, mitgeführt wird.

Dieses Paket von Multilayer-Innenlagen mit dazwischenliegenden Prepreg-Bahnen wird durch die kontinuierlich vorlaufende Stiftkette zur Doppelbandpresse transportiert und in dieser unter Einwirkung von Wärme und Druck zur Multilayer-Leiterplatte verpreßt. Die gemäß der zweiten Vorgehensweise hergestellten Multilayer-Innenlagenbahnen werden vor der Doppelbandpresse entsprechend dem Aufbau der Multilayer-Leiterplatte von Abwickeleinheiten abgewickelt und mittels der Fixierlöcher auf die Stiftkette aufgelegt, wobei sich wiederum zwischen jeweils zwei MultilayerInnenlagenbahnen eine Prepreg-Bahn, die von einer Abwickelrolle abgewickelt wird, befindet. Dieses Paket aus Multilayer-Innenlagenbahnen mit dazwischenliegenden Prepreg-Bahnen wird von der Stiftkette in Richtung Doppelbandpresse transportiert und in dieser zu einer Multilayer-Bahn verpreßt. Hinter der Doppelbandpresse befindet sich eine Quersäge, in der die einzelnen Multilayer-Leiterplatten aus der Multilayer-Bahn wiederum in Referenz zu den Fixierlöchern ausgesägt werden.

Nachteilig bei dieser bekannten Vorrichtung ist die aufwendige Steuerung des Synchronlaufs der beiden Stiftketten sowie des Gleichlaufs der Stiftketten mit den Preßbändern der Doppelbandresse. Geringe Geschwindigkeitsunterschiede zwischen den Stiftketten untereinander oder zu den Preßbändern führen zu einer Verschiebung der einzelnen Multilayer-Innenlagen oder Multilayer-Innenlagenbahnen und zu Faltenbildungen, womit letztendlich die hergestellte Multilayer-Leiterplatte unbrauchbar wird. Weiterhin ist eine exakt parallele Führung der Stiftketten zu den Preßbändern erforderlich, um Ausschuß zu vermeiden. Transport- und Steuerbewegungen können Schwingungen der Stiftketten verursachen und Schwankungen in der Vorspannung der Kette können ein Spiel zwischen den Kettengliedern hervorrufen, wodurch die parallele Führung der beiden Stiftketten beeinträchtigt wird. Außerdem ist die Herstellung der Stiftkette innerhalb den geforderten engen Toleranzen, von maximal ca. 1/100 mm, die zur Herstellung von Multilayer-Leiterplatten erforderlich ist, sehr schwierig und damit sehr teuer.

Ausgehend von diesem Stand der Technik liegt der Erfindung die Aufgabe zu grunde, die Vorrichtung zur kontinuierlichen Herstellung von Multilayer-Leiterplatten so weiterzuentwickeln, daß auf die zwei von der Doppelbandpresse unabhängigen Stiftketten verzichtet werden kann.

Die Lösung dieser Aufgabe wird durch die im Kennzeichen des Patentanspruchs 1 beschriebene technische Lehre vermittelt.

Die mit der Erfindung erzielbaren Vorteile bestehen darin, daß keine Unterschiede zwischen den Vorschubgeschwindigkeiten der in die Fixierlöcher an den beiden Rändern der Multilayer-Innenlagen oder Multilayer-Innenlagenbahnen eingreifenden Vorsprünge sowie im Verhältnis zu den Preßbändern auftreten können. Dadurch erübrigt sich eine aufwendige Steuer- oder Regelvorrichtung zur Synchronisation der Vorschubgeschwindigkeit der Vorsprünge mit derjenigen der Preßbänder. Verschiebungen von einzelnen Multilayer-Innenlagen werden somit vermieden und der Ausschuß wird reduziert. Die zusätzlichen Führungseinrichtungen durch die Doppelbandpresse, die für die Stiftketten erforderlich sind, entfallen, da die Vorsprünge in das Preßband zu einem Stiftband integriert sind. Das Preßband mit den integrierten Vorsprüngen selbst ist konstruktiv einfacher und auch billiger herzustellen als die Stiftketten.

Ein bevorzugtes Ausführungsbeispiel der Erfindung ist in den Zeichnungen dargestellt und wird im folgenden näher beschrieben. Es zeigen

Fig. 1 eine Vorrichtung zur Herstellung von kupferkaschierten Laminaten,

Fig. 2 eine Multilayer-Innenlagenbahn mit Fixierlöchern in Draufsicht,

Fig. 3 eine Vorrichtung zur kontinuierlichen Herstellung von Multilayer-Leiterplatten aus Multilayer-Innenlagenbahnen,

Fig. 4 eine Vorrichtung zur kontinuierlichen Herstellung von Multilayer-Leiterplatten aus Multilayer-Innenlagen,

Fig. 5 mehrere Ausführungsformen für das Stiftband und

Fig. 6 schematisch einen Schnitt durch eine Doppelbandpresse mit Stiftband.

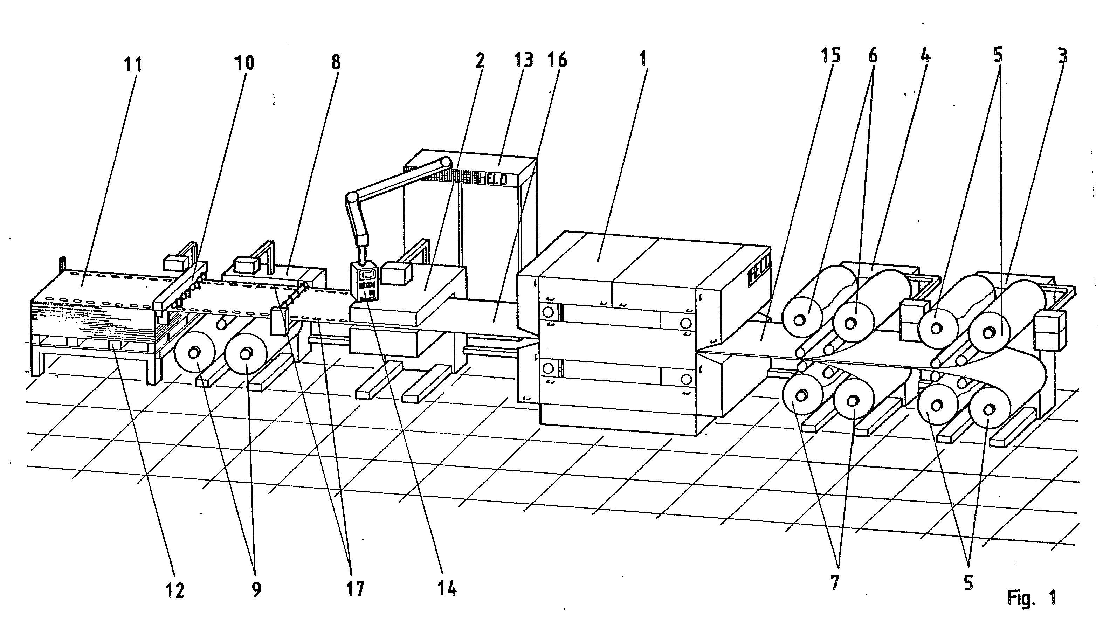

Die in Fig. 1 schematisch dargestellte kontinuierlich arbeitende Vorrichtung zur Herstellung von kupferkaschierten Laminaten ist aus der DE-OS 33 07 057 bekannt und besteht aus einer kontinuierlich arbeitenden Doppelbandpresse 1, einer Stanzeinrichtung 2 für die Fixierlöcher 17, Abwickeleinheiten 3 und 4 mit Vorratsrollen 5 für das Prepreg und 6, 7 für die Kupferfolie, einer Wickelstation 8 mit Rollen 9 für dünne kupferkaschierte Laminatbahnen, einer mitlaufenden Schere 10 und einem Schaltschrank 13 mit Datensichtgerät 14.

Die aus beharztem, vorkondensiertem Gewebe bestehenden Prepreg-Bahnen für den Schichtstoffkern werden von Rollen 5 in der Abwickeleinheit 3 abgezogen und mit Kupferfolien, die von Rollen 6, 7 in der Abwickeleinheit 4 abgezogen werden so zu einem Schichtgebilde 15, zusammengeführt, daß die Pregpregbahnen zwischen den beiden Kupferfolienbahnen liegen. Dieses Schichtgebilde 15 wird in der Doppelbandpresse 1 unter Einwirkung von Wärme und Flächendruck zur kupferkaschierten Laminatbahn 16 verpreßt. In einer Stanzeinrichtung 2 werden anschließend Fixierlöcher 17, die in Fig. 1 aus darstellerischen Gründen übertrieben groß eingezeichnet sind, in regelmäßigen Abständen entlang der beiden Ränder der kupferkaschierten Laminatbahn 16 eingebracht. Ein Rechner im Schaltschrank 13, der über das Datensichtgerät 14 vom Bediener mit Eingaben versorgt wird, steuert den gesamten Produktionsablauf und auch das Stanzen der einzelnen Fixierlöcher 17 mit einer Frequenz, die von der Vorschubgeschwindigkeit der kupferkaschierten Laminatbahn 16 in der Doppelbandpresse 1 abhängig ist. Damit wird erreicht, daß die Abstände der einzelnen Fixierlöcher 17 unter allen Betriebsbedingungen der Vorrichtung zur Herstellung kupferkaschierter Laminate gleich bleiben, was für die präzise Herstellung der Multilayer- Leiterplatten unerläßlich ist. In der Stanzeinrichtung 2 befindet sich gleichzeitig eine Kühl- und Reinigungseinrichtung, in der die kupferkaschierte Laminatbahn 16 abgekühlt und deren Oberfläche gereinigt wird. In der Wickelstation 8 wird die kupferkaschierte Laminatbahn 16 auf Rollen 9 aufgewickelt, falls es sich um eine dünne, flexible kupferkaschierte Laminatbahn handelt. Alternativ kann die kupferkaschierte Laminatbahn 16 mit der Schere 10 in kupferkaschierte Platten 11 aufgeteilt werden, die in Paletten 12 gestapelt werden.

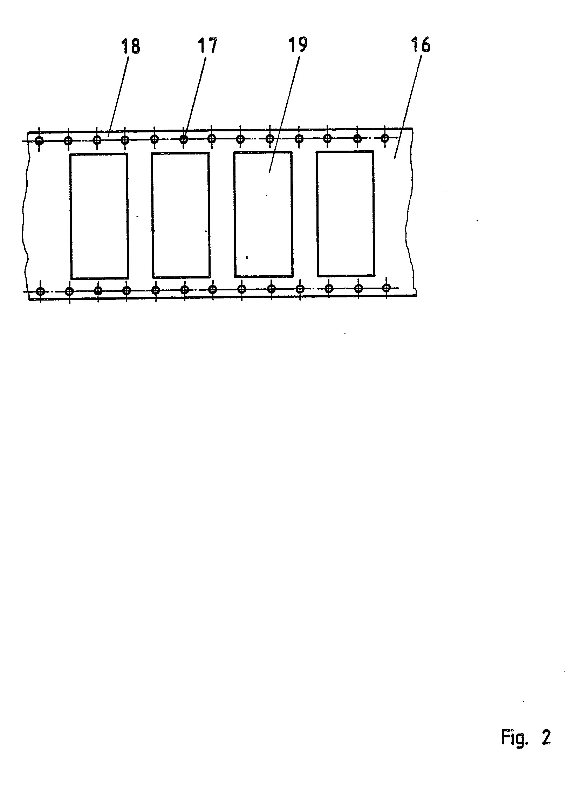

Diese kupferkaschierten Laminatbahnen 16, die auf Rollen 9 aufgewickelt sein können, oder kupferkaschierten Platten 11 werden anschließend zu Multilayer-Leiterplatten weiterverarbeitet. In Fig. 2 ist die Draufsicht auf eine solche kupferkaschierte Laminatbahn 16 mit den an den beiden Rändern in der Stanzeinrichtung 2 eingebrachten Fixierlöchern 17 zu sehen. Die Fixierlöcher 17, deren Mittelpunkte einen konstanten Abstand voneinander besitzen, befinden sich entlang eines Lochrandes 18. In Referenz zu diesen Fixierlöchern 17 lassen sich dann Ätzresistflächen 19 zum Ätzen des gewünschten Leiterbahnmusters festlegen. Auf jede dieser Ätzresistflächen 19 wird das gewünschte Leiterbahnmuster einer Multilayer-Innenlage der Multilayer-Leiterplatte wie bekannt aufgedruckt oder mit fotografischen Mitteln oder dergleichen aufgebracht. Beim anschließenden Ätzen der Kupferschicht der kupferkaschierten Laminatbahn 16 wird das Kupfer soweit weggeätzt, daß nur noch die Leiterbahnzüge stehen bleiben. Vorteilhafterweise wird auf einer kupferkaschierten Laminatbahn 16 immer dasselbe Leiterbahnmuster einer einzigen Multilayer-Innenlage auf den hintereinander liegenden Ätzresistflächen 19 hergestellt, so daß man eine entsprechende Multilayer-Innenlagenbahn erhält, auf der sich regelmäßig hintereinander angeordnet dasselbe Leiterbahnmuster befindet. Die weitere Bearbeitung, wie Bohren, Fräsen, etc., dieser auf der Multilayer-Innenlagenbahn befindlichen Multilayer-Innenlagen erfolgt ebenfalls in Referenz zu den Fixierlöchern 17. Eine solche Multilayer-Innenlagenbahn wird für jede Multilayer-Innenlage der Multilayer-Leiterplatte angefertigt.

Ist die kupferkaschierte Laminatbahn 16 bereits in einzelne kupferkaschierte Platten 11 aufgeteilt, so wird das jeweilige Leiterbahnmuster einer Multilayer-Innenlage auf die kupferkaschierte Platte 11 in Referenz zu den Fixierlöchern 17 aufgebracht und diese kupferkaschierte Platte 11 dann durch Ätzen, Bohren, Stanzen, Fräsen und dergleichen zur entsprechenden Multilayer-Innenlage weiterbearbeitet, wobei als Referenz jeweils die Fixierlöcher 17 dienen.

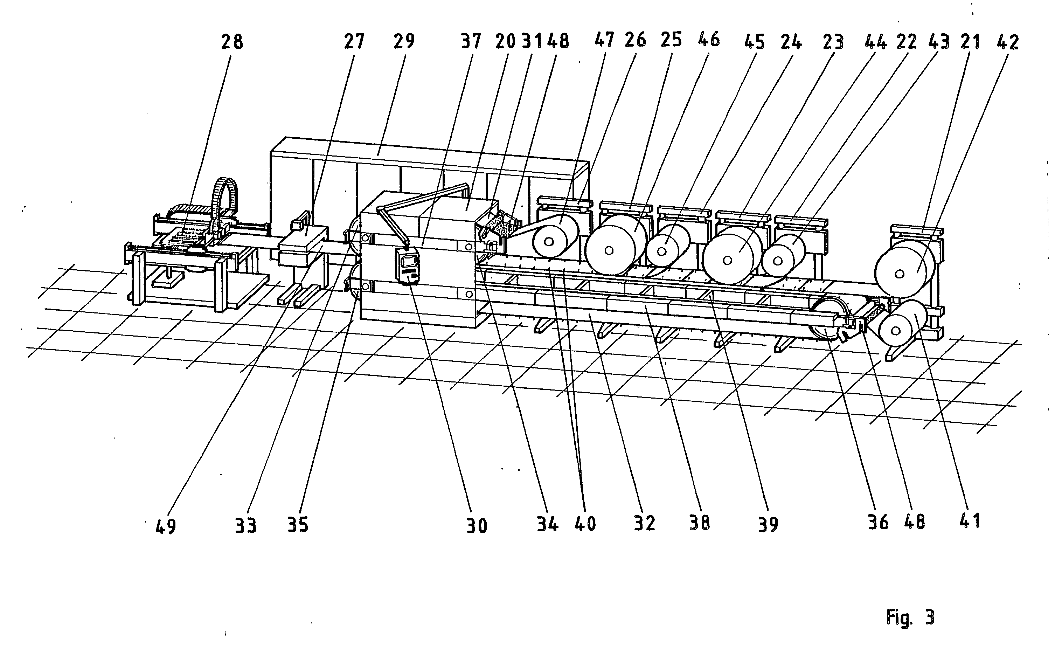

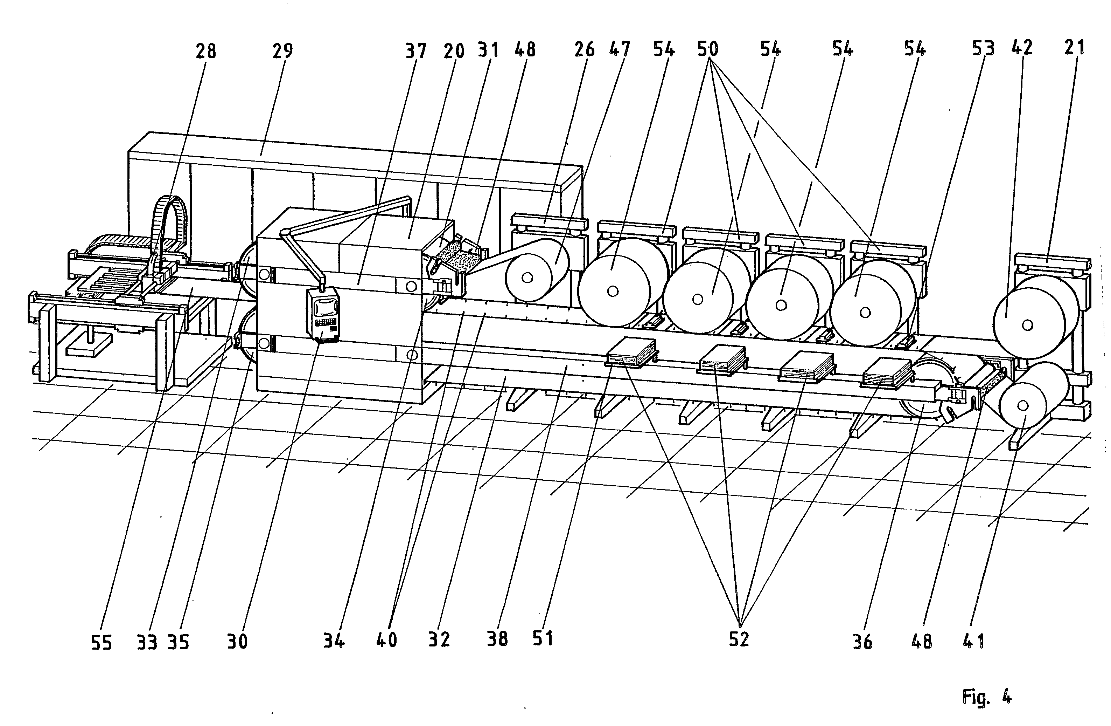

Zur Verpressung der wie beschrieben erhaltenen einzelnen Multilayer-Innenlagenbahnen zu einer Multilayer-Bahn oder der einzelnen Multilayer-Innenlagen zu einer Multilayer-Leiterplatte werden die entsprechenden Multilayer-Innenlagenbahnen oder Multilayer-Innenlagen anhand der Fixierlöcher zentriert in der gewünschten Reihenfolge aufeinandergelegt, zwischen den Multilayer-Innenlagen jeweils eine Prepreg-Bahn angeordnet, auf die Oberfläche dieses Schichtgebildes jeweils eine Prepreg-Bahn und Kupferfolie für die Multilayer-Außenlage aufgelegt und anschließend Druck und Wärme ausgesetzt. Die dazu verwendeten Vorrichtungen werden in Fig. 3 und 4 näher gezeigt.

Die in Fig. 3 schematisch gezeigte Vorrichtung zur Herstellung von Multilayer-Leiterplatten besteht aus einer kontinuierlich arbeitenden Doppelbandpresse 20, mehreren vor dieser Doppelbandpresse angeordneten Abwickeleinheiten 21 bis 26, einer hinter der Doppelbandpresse 20 angeordneten Kühl- und Reinigungseinrichtung 27 und einer Quersäge 28. Der gesamte Produktionsablauf der in Fig. 3 gezeigten Vorrichtung wird von einem Rechner in einem Schaltschrank 29 gesteuert. Eingaben des Bedieners für den Rechner im Schaltschrank 29 erfolgen über ein Datensichtgerät 30.

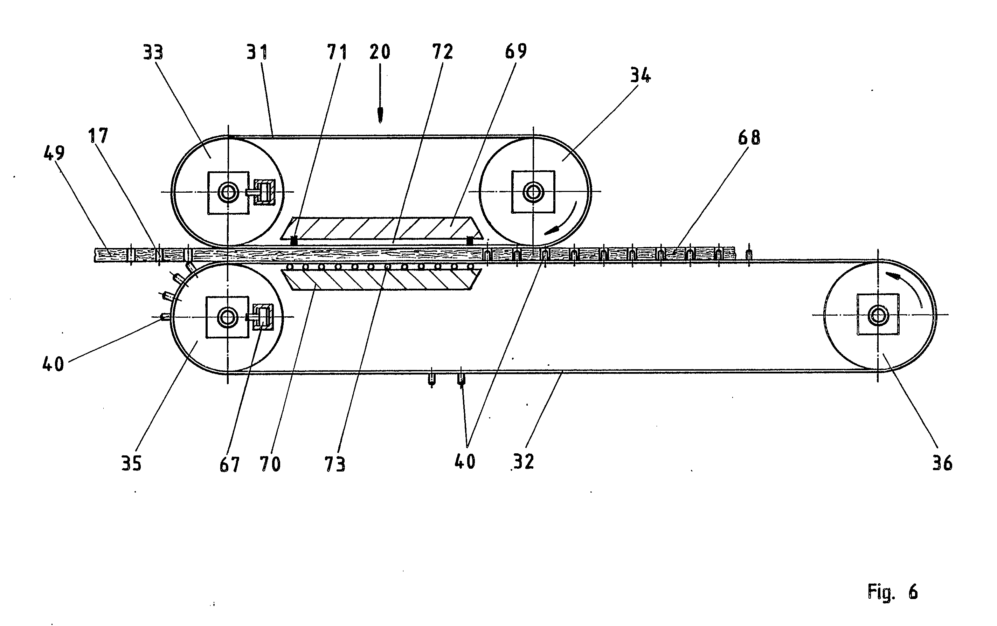

Die Doppelbandpresse 20 besitzt, wie in Fig. 6 zu sehen ist, zwei in einem Pressengestell übereinander angeordnete Preßbänder 31, 32, die über je zwei Umlenkrollen 33, 34 bzw. 35, 36 endlos geführt sind. Die Preßbänder 31, 32 werden mittels Hydraulikzylinder 67 gespannt. Die Umlenkrollen 33, 34, 35, 36 sind wiederum in am Pressengestell befestigten Lagerbrücken 37, 38 drehbar gelagert (siehe Fig. 3). Der Aufbau des Pressengestells für eine solche Doppelbandpresse ist an sich bekannt und kann beispielsweise der DE-OS 32 34 082 entnommen werden. Das untere Preßband 32 ist vor die Doppelbandpresse 20 herausgezogen, indem die untere Lagerbrücke 38 und der dazugehörige Teil 39 des Pressengestells am Einlauf in die Doppelbandpresse 20 in horizontaler Richtung verlängert sind und sich die Umlenktrommel 36 für das Preßband 32 am äußersten Ende dieser Verlängerung befindet. Dadurch bildet der außerhalb der Doppelbandpresse 20 befindliche Teil des Preßbandes 32 ein Förderband für die in die Doppelbandpresse 20 zu transportierenden Multilayer-Innenlagen- und Prepreg-Bahnen. Das untere Preßband 32 ist entlang seinen beiden Rändern mit als Stiftzähnen ausgebildeten Vorsprüngen 40 versehen, die genau denselben Abstand wie die Fixierlöcher 17 des Lochrandes 18 der kupferkaschierten Laminatbahn 16 und den Durchmesser der Fixierlöcher 17 besitzen, das heißt die Stiftzähne bilden zu den Fixierlöchern 17 korrespondierende, auf dem Preßband 32 angeordnete Vorsprünge 40. Aus Gründen der Übersichtlichkeit sind in Fig. 6 nur einige dieser Stiftzähne eingezeichnet.

Wie der Fig. 3 zu entnehmen ist, ist vor der Umlenkrolle 36 eine Abwickeleinheit 21 angebracht, die eine Rolle 41 für eine elektrolytisch abgeschiedene Kupferfolie und eine Rolle 42 für das Prepreg enthält. Von der Rolle 41 wird die Kupferfolie kontinuierlich abgezogen und an der Umlenktrommel 36 auf das Preßband 32 geführt. Auf diese Kupferfolie wird eine von der Rolle 42 abgewickelte Prepreg-Bahn aufgelegt und diese zusammen mit dem Preßband in Richtung Doppelbandpresse 20 transportiert. Während dieses Transports wird eine erste Multilayer-Innenlagenbahn von einer Rolle 43 in der Abwickeleinheit 22 abgewickelt und mit den Fixierlöchern 17 auf die Stiftzähne 40 des Preßbandes 32 aufgelegt. Anschließend auf diese Multilayer-Innenlagenbahn wird eine Prepreg-Bahn, die von einer Rolle 44 in der Abwickeleinheit 23 abgewickelt wird, aufgelegt. Es folgen dann weitere Multilayer-Innenlagenbahnen, die von Rollen 45 in Abwickeleinheiten 24 abgewickelt werden und durch von Rollen 46 in Abwickeleinheiten 25 abgezogenen Prepreg-Bahnen getrennt werden. Die Anzahl dieser Multilayer-Innenlagen-Bahnen und damit der Abwickeleinheiten 24, 25 wird nach dem gewünschten Aufbau der Multilayer-Leiterplatte bestimmt. Die Zentrierung der einzelnen Multilayer-Innenlagen paßgenau übereinander wird mit Hilfe der Stiftzähne 40 erreicht, die in die entsprechenden Fixierlöcher 17 am Lochrand 18 der Multilayer-Innenlagenbahnen eingreifen. Dabei ist es nur jeweils am Beginn einer Rolle für die Multilayer-Innenlagenbahn erforderlich, diese entsprechend dem Leiterbahnmuster, das in Referenz zu den Fixierlöchern 17 aufgebracht ist, auf die darunterliegende Multilayer-Innenlagenbahn aufzulegen, da die Leiterbahnmuster auf jeder Multilayer-Innenlagenbahn in regelmäßigen Abständen hintereinanderliegend folgen. Auf die oberste Prepreg-Schicht wird schließlich eine Kupferfolie aufgelegt, die von einer Rolle 47 in der Abwickeleinheit 26 über die Umlenktrommel 34 zugeführt wird. Die einlaufseitigen Umlenktrommeln 34 und 36 sind wie bekannt beheizbar ausgebildet und wärmen somit die Kupferfolien zur Vermeidung von Faltenbildungen vor. Zur Reinigung der Kupferfolienoberflächen können an den einlaufseitigen Umlenktrommeln 34 und 36 Reinigungseinrichtungen 48 angebracht sein, die Staub und Schmutz von den Kupferfolien entfernen. Solche Reinigungseinrichtungen 48 sind in der DE-OS 35 33 413 beschrieben. Anstelle der oberen und unteren Kupferfolie können auch bereits fertige Multilayer-Außenlagen, die ebenfalls Fixierlöcher besitzen, aufgelegt werden.

Dieses Schichtgebilde 68, das aus den durch Prepreg-Bahnen getrennten Multilayer-Innenlagenbahnen und aus Kupferfolien, die an den oberflächigen Prepreg-Bahnen anliegen, gebildet wird, wird in der Doppelbandpresse 20 zwischen den beiden Preßbändern 31, 32 unter Einwirkung von Flächendruck und Wärme unter gleichzeitiger Förderung durch die Doppelbandpresse 20 verpreßt. Zur Ausübung des Flächendrucks auf das Schichtgebilde 68 befinden sich auf der Rückseite der Preßbänder 31, 32 Druckplatten 69, 70, von denen ein Preßdruck über fluide oder mechanische Mittel auf das Preßband 31, 32 übertragen wird (siehe Fig. 6). Bei der Druckübertragung mit fluiden Mitteln sind in der Druckplatte 69 ringförmig in sich geschlossene Dichtungen 71 angeordnet, die mit einer Fläche die Innenseite des Preßban des 31 gleitend berühren. Dadurch wird zwischen diesen Dichtungen 71, der Druckplatte 69 und der Innenseite des Preßbandes 31 eine Druckkammer 72 gebildet, in der ein fluides Medium unter Druck eingebracht ist. Bei der Druckübertragung mit mechanischen Mitteln befinden sich an der Druckplatte 70 ortsfest angeordnete Rollen 73, die den Druck von der Druckplatte 70 auf die Innenseite des Preßbandes 32 übertragen.

Die in die Fixierlöcher 17 eingreifenden Stiftzähne 40 des Preßbandes 32 halten die Multilayer-Innenlagenbahnen auch unter dem Preßdruck fixiert, so daß ein Verschieben oder Verwerfen einzelner Multilayer-Innenlagen ausgeschlossen ist und diese paßgenau übereinander liegen. Falls gewünscht, kann in der Doppelbandpresse anschließend noch eine Kühlzone integriert sein, in der das Schichtgebilde 68 unter Flächendruck abgekühlt wird. Am Auslauf der Doppelbandpresse 20 ist das Harz der Prepreg-Bahnen ausgehärtet und verbindet die einzelnen Bahnen des Schichtgebildes miteinander zu einer kompakten Multilayer-Bahn 49, in der die einzelnen Multilayer-Leiterplatten in regelmäßigen Abständen hintereinander angeordnet sind. Wie in Fig. 3 zu sehen ist, wird diese Multilayer-Bahn 49 anschließend durch eine Reinigungs- und Kühleinrichtung 27 hindurchgeführt, in der die aus Kupferfolien bestehenden Oberflächen der Multilayer-Bahn mit einem Lösungsmittel gereinigt werden. Hinter der Kühleinrichtung 27 folgt eine Quersäge 28, in der die einzelnen Multilayer-Leiterplatten aus der Multilayer-Bahn 49 ausgeschnitten werden. Die Multilayer-Leiterplatten können dann wiederum zum Abtransport auf Paletten gestapelt werden. Die Leiterbahnmuster der Multilayer-Außenlagen können bereits hinter der Kühleinrichtung 27 in einer in Fig. 3 nicht gezeigten Bearbeitungsstation in Referenz zu den Fixierlöchern 17 hergestellt werden. Alternativ können diese Leiterbahnmuster der Multilayer-Außenlagen auch erst hergestellt werden, nachdem die Multilayer-Bahn 49 bereits in einzelne Multilayer-Leiterplatten in der Quersäge 28 aufgeteilt ist. Der Lochrand 18 wird zweckmäßigerweise erst dann besäumt, wenn die Multilayer-Außenlage fertig bearbeitet ist.

In Fig. 4 ist eine weitere Ausführungsform einer erfindungsgemäßen Vorrichtung zur Herstellung von Multilayer-Leiterplatten gezeigt. Die Doppelbandpresse 20 ist im wesentlichen identisch zu derjenigen der, Fig. 3 bzw. Fig. 6 aufgebaut. Anstelle von Multilayer-Innenlagenbahnen werden nun jedoch einzelne Multilayer-Innenlagen zu einer Multilayer-Leiterplatte verpreßt. Dazu sind an der unteren Lagerbrücke 38 Trägerplatten 51 angebracht, auf denen sich je ein Stapel 52 von gleichen Multilayer-Innenlagen befindet. Die Reihenfolge der Stapel 52 entspricht der gewünschten Reihenfolge der Multilayer-Innenlagen in der Multilayer-Leiterplatte. Bei der den Trägerplatten 51 gegenüberliegenden Seite des Preßbandes 32 befinden sich Abwickeleinheiten 50 für Rollen 54 von Prepreg-Bahnen.

Bei der in Fig. 4 gezeigten Vorrichtung wird eine Kupferfolie von einer Rolle 41 in einer Abwickeleinheit 21 abgewickelt und auf das Preßband 32 aufgelegt. Auf diese Kupferfolie wird eine Prepreg-Bahn, die von einer Rolle 42 in der Abwickeleinheit 21 abgewickelt wird, angeordnet. Anschließend wird die erste Multilayer-Innenlage vom Stapel 52 mittels einer Auflegeeinrichtung 53 auf die Prepreg-Bahn aufgelegt, wobei die Stiftzähne 40 in die Fixierlöcher 17 am Lochrand 18 eingreifen. Die Auflegeeinrichtung 53 kann beispielsweise aus einer verfahrbaren Vakuumsaugplatte bestehen. Auf diese erste Multilayer-Innenlage wird eine Prepreg-Bahn, die von einer Rolle 54 in einer Abwickeleinheit 50 abgezogen wird, geschichtet. Anschließend wird vom nächsten Stapel 52 die folgende Multilayer-Innenlage mittels einer Auflegeeinrichtung 53 auf die Prepreg-Bahn aufgelegt, wobei die zweite Multilayer-Innenlage durch die Fixierlöcher 17 zentriert über der ersten Multilayer-Innenlage angeordnet wird. Die Stiftzähne 40 greifen dabei ebenfalls in die Fixierlöcher 17 der zweiten Multilayer-Innenlage ein. Anschließend folgen weitere Prepreg-Bahnen von Rollen 54 aus der Abwickeleinheit 50 abwechselnd mit weiteren Multilayer-Innenlagen von den Stapeln 52. Auf die oberste Multilayer-Innenlage wird wiederum eine Prepreg-Bahn und anschließend eine Kupferfolie von einer Rolle 47 aus einer Abwickeleinrichtung 26 aufgelegt. Dieses aus den Multilayer-Innenlagen, Prepreg-Bahnen und Kupferfolien bestehende Schicht gebilde 68 wird durch das Preßband 32 in die Doppelbandpresse 20 transportiert und in dieser mit Flächendruck und Wärme zu einer Multilayer-Bahn 55 verpreßt, wobei die Stiftzähne 40 des Preßbandes 32 die einzelnen Multilayer-Innenlagen fixiert zueinander halten. Nachdem die Multilayer-Bahn 55 die Doppelbandpresse 20 verlassen hat, werden mittels einer Quersäge 28 die einzelnen Multilayer-Leiterplatten ausgeschnitten, wobei die Fixierlöcher 17 wiederum als Referenz dienen. In Referenz zu den Fixierlöchern 17 werden danach die Leiterbahnmuster für die Multilayer-Außenlagen in die an den Oberflächen der Multilayer-Platten befindlichen Kupferfolien eingebracht. Die Fixierlöcher 17 des Lochrandes 18 können anschließend besäumt werden, falls sie nicht mehr gebraucht werden. Die Multilayer-Platten werden auf Paletten zum Transport abgestapelt.

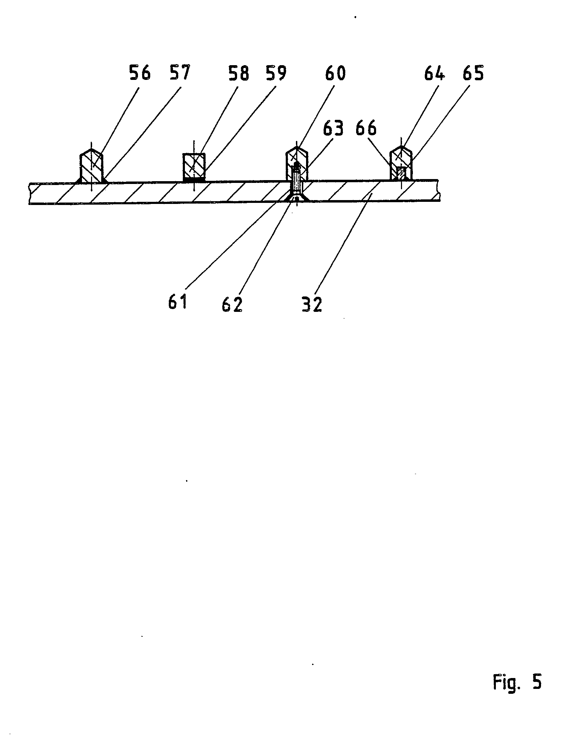

In Fig. 5 sind mehrere Ausführungsformen für das mit Stiftzähnen als zu den Fixierlöchern 17 korrespondierenden Vorsprüngen 40 versehene Preßband 32 dargestellt. In einer ersten Ausführungsform ist der Stiftzahn 56, der im wesentlichen einen zylindrischen Körper mit einem spitz zulaufenden, kegelförmigen oberen Ende besitzt, mit dem Preßband 32 durch eine Schweißnaht 57 verbunden. Genauso gut kann der Stiftzahn 56 mit dem Preßband verlötet sein. Das spitz zulaufende Ende des Stiftzahnes 56 erleichtert das Auflegen der Multilayer-Innenlagen auf die Stiftzähne in den Fixierlöchern 17. Der Stiftzahn kann jedoch auch eine andere zweckmäßige Form besitzen, beispielsweise einen Zylinder ohne Spitze am Ende, wie er mit dem Bezugszeichen 58 gezeigt ist. Dieser Stiftzahn 58 ist mittels einer Klebschicht 59 auf dem Preßband 32 befestigt. Der Stiftzahn 60 ist auf dem Preßband festgeschraubt. Dazu besitzt das Preßband 32 an der Befestigungsstelle eine Durchgangsbohrung 61, und der Stiftzahn 60 ein Gewindeloch 63. Mittels einer Senkkopfschraube 62 wird der Stiftzahn 60 nun von der dem Stiftzahn 60 abgelegenen Seite des Preßbandes 32 mit dem Preßband 32 verschraubt, wobei der Kopf der Schraube 62 eine ebene Fläche mit dem Preßband 32 bildet. Bei einer weiteren Befestigungsmöglichkeit ist ein zylindrischer Zapfen 65 mit dem Preßband verschweißt. Der Stiftzahn 64 besitzt eine im Querschnitt kreisförmige Nut 66, deren Durchmesser gerade dem Durchmesser des Zapfens 65 entspricht und ist mit dieser Nut 66 auf den Zapfen 65 aufgesteckt. Die beiden letztgenannten Ausführungsbeispiele für den Stiftzahn 60 und 64 besitzen den Vorteil, daß sie leicht auswechselbar sind. Dadurch können die Stiftzähne durch andere mit unterschiedlicher Höhe leicht ersetzt werden, falls dies aufgrund unterschiedlicher Dicken der herzustellenden Multilayer-Leiterplatten erforderlich sein sollte.

Das vorgezogene untere Preßband 32 erleichtert das Auflegen der Multilayer-Innenlagen. Es kann jedoch auch ein normales Preßband mit Stiftzähnen versehen werden, das nicht aus der Doppelbandpresse herausgezogen ist. Anstelle des unteren Preßbandes kann auch das obere Preßband 31 mit den Stiftzähnen versehen werden bzw. beide Preßbänder 31 und 32 können mit Stiftzähnen versehen sein. Erfindungswesentlich ist, daß mindestens ein Preßband der Doppelbandpresse mit diesem verbundene Vorsprünge aufweist, die in regelmäßigen Abständen angeordnet sind und zu den Fixierlöchern 17 des Lochrandes 18 der kupferkaschierten Laminatbahn 16 korrespondieren.

**Ansprüche**

1. Vorrichtung zur kontinuierlichen Herstellung von Multilayer-Leiterplatten mit einer zwei endlose, in einem Pressengestell übereinander angeordnete und über je zwei Umlenktrommeln geführte Preßbänder besitzende Doppelbandpresse zur Verpressung von Multilayer-Innenlagen, an deren Rändern Fixierlöcher eingebracht sind, wobei vor der Doppelbandpresse hintereinanderliegende Abwickeleinheiten für die auf einer Rolle vorliegenden Multilayer-Innenlagenbahnen mit dazwischen liegenden Abwickeleinheiten für die Prepreg-Bahnen oder Auflegeeinrichtungen für die als Platten vorliegenden Multilayer-Innenlagen mit dazwischen liegenden Abwickeleinheiten für die Prepreg-Bahnen angeordnet sind und mit in die Fixierlöcher eingreifenden Mitteln, die ein paßgenaues Übereinanderlegen der Multilayer-Innenlagen zu einem die Multilayer-Anordnung darstellenden Schichtgebilde und eine Fixierung der Multilayer-Innenlagen dieses Schichtgebildes während der Verpressung in der Doppelbandpresse gestatten, **dadurch gekennzeichnet,** daß die in die Fixierlöcher 171 eingreifenden Mittel aus Vorsprüngen (40) bestehen, die an wenigstens einem Preßband (31, 32) der Doppelbandpresse (20) an mindestens einem Rand in regelmäßigen Abständen auf der Außenseite des Preßbandes (31, 32) angebracht sind und daß diese Vorsprünge (40) zu den Fixierlöchern (17) korrespondieren.

2. Vorrichtung nach Anspruch 1, **dadurch gekennzeichnet,** daß das die Vorsprünge (40) besitzende Preßband (32) vor die Doppelbandpresse (20) vorgezogen ist und gleichzeitig als Transportband für das die Multilayer-Anordnung darstellende Schichtgebilde (68) in die Doppelbandpresse (20) dient, indem der zu diesem Preßband (32) gehörige Teil des Pressengestells am Einlauf in die Doppelbandpresse (20) in horizontaler Richtung verlängert ist und die einlaufseitige Umlenktrommel (36) für das Preßband (32) sich am äußersten Ende dieser Verlängerung befindet.

3. Vorrichtung nach Anspruch 1 oder 2, **dadurch gekennzeichnet,** daß die zu den Fixierlöchern (17) korrespondierenden Vorsprünge (40) am unteren Preßband (32) angebracht sind.

4. Vorrichtung nach Anspruch 1 oder 2, **dadurch gekennzeichnet,** daß die zu den Fixierlöchern (17) korrespondierenden Vorsprünge (40) am oberen Preßband (31) angebracht sind.

5. Vorrichtung nach Anspruch 1 oder 2, **dadurch gekennzeichnet,** daß sowohl am oberen (31) als auch unteren Preßband (32) die zu den Fixierlöchern (17) korrespondierenden Vorsprünge (40) angebracht sind.

6. Vorrichtung nach einem der Ansprüche 1 bis 5, **dadurch gekennzeichnet,** daß die korrespondierenden Vorsprünge (40) als am Preßband (31, 32) angeordnete Stiftzähne (56, 58, 60, 64) ausgebildet sind.

7. Vorrichtung nach Anspruch 6, **dadurch gekennzeichnet,** daß die Stiftzähne (56, 58, 60, 64) zylinderförmig ausgebildet sind.

8. Vorrichtung nach Anspruch 7, **dadurch gekennzeichnet,** daß die Stiftzähne (56, 60, 64) an dem dem Preßband (32) abgewandten Ende kegelförmig spitz zulaufen.

9. Vorrichtung nach einem der Ansprüche 1 bis 8, **dadurch gekennzeichnet,** daß die zu den Fixierlöchern (17) korrespondierenden Vorsprünge (40, 56, 58) am Preßband (31, 32) fest angebracht sind.

10. Vorrichtung nach Anspruch 9, **dadurch gekennzeichnet,** daß die zu den Fixierlöchern (17) korrespondierenden Vorsprünge (56) mit dem Preßband (32) verschweißt sind.

11. Vorrichtung nach Anspruch 9, **dadurch gekennzeichnet,** daß die zu den Fixierlöchern (17) korrespondierenden Vorsprünge (56) am Preßband (32) verlötet sind.

12. Vorrichtung nach Anspruch 9, **dadurch gekennzeichnet,** daß die zu den Fixierlöchern (17) korrespondierenden Vorsprünge (58) mit dem Preßband (32) verklebt sind.

13. Vorrichtung nach einem der Ansprüche 1 bis 8, **dadurch gekennzeichnet,** daß die zu den Fixierlöchern (17) korrespondierenden Vorsprünge (40, 60, 64) am Preßband (31, 32) auswechselbar angebracht sind.

14. Vorrichtung nach Anspruch 13, **dadurch gekennzeichnet,** daß die zu den Fixierlöchern (17) korrespondierenden Vorsprünge (60) mit dem Preßband (31, 32) verschraubt sind.

15. Vorrichtung nach Anspruch 14, **dadurch gekennzeichnet,** daß der Vorsprung (60) ein dem Preßband (32) zugewandtes Gewindeloch (63) besitzt, in das eine Senkkopfschraube (62) von der dem Vorsprung (60) abgewandten Seite des Preßbandes (32) eingreift.

16. Vorrichtung nach Anspruch 13, **dadurch gekennzeichnet,** daß der Vorsprung (64) eine dem Preßband (32) zugewandte Nut (66) besitzt und mit dieser Nut (66) auf einen am Preßband (32) befestigten Zapfen (65) aufgesteckt ist.

17. Vorrichtung nach Anspruch 16, **dadurch gekennzeichnet,** daß der Zapfen (65) mit dem Preßband (32) verschweißt oder verlötet ist.

18. Vorrichtung nach Anspruch 16 oder 17, **dadurch gekennzeichnet,** daß sowohl der Zapfen (65) als auch die Nut (66) einen kreisförmigen Querschnitt mit ungefähr denselben Durchmesser besitzen.

Fig. 1

Fig. 2

28  27 29  37 20 31 48 47 26 25 46 45 24 23 44 22 43 21 42

EP 0 327 838 A2

49  33 35   30  34 40 32 38 39  36 48 41

Fig. 3

Fig. 4

Fig. 5

Fig. 6